# EUROPEAN PATENT SPECIFICATION

(11) **EP 4 109 120 B1**
(45) Date of publication and mention of the grant of the patent: **05.11.2025**
(21) Application number: 21181265.6
(22) Date of filing: 23.06.2021
(51) Int. Cl.: G01R 31/396, G01R 31/371, H01M 10/48

(54) **BATTERY MANAGEMENT SYSTEM AND METHOD**
BATTERIEVERWALTUNGSSYSTEM UND VERFAHREN
SYSTÈME ET PROCÉDÉ DE GESTION DE BATTERIE

(43) Date of publication of application: 28.12.2022
(73) Proprietor: C.R.F. Società Consortile per Azioni, 10043 Orbassano (Torino) (IT)
(72) Inventor: PRIMON, Alfredo, 10043 Orbassano (Torino) (IT); BRANCATI, Benedetto, 10043 Orbassano (Torino) (IT)
(74) Representative: Buzzi, Notaro & Antonielli d'Oulx S.p.A.

(56) References cited:
- EP-A1- 3 536 542
- EP-A1- 3 547 705
- EP-A2- 1 777 794
- WO-A1-2017/203265
- WO-A1-2019/022378
- JP-A- 2021 019 371
- US-A1- 2014 347 014
- US-A1- 2016 268 642
- US-A1- 2020 099 111
- US-A1- 2021 098 833
- US-B2- 9 902 277

## Description

### Field of the invention

The present invention relates to a battery management system and a corresponding battery management method, for a battery pack comprising a plurality of battery modules, that each include a plurality of battery cells, wherein a plurality of module controllers are provided, which are respectively associated with the battery modules, each module controller being configured to receive information on voltage and temperature of the battery cells forming the respective module, and wherein each module controller is provided with a respective wireless communication unit.

### Prior art

A battery management system having the above mentioned characteristics is described, for example, in document EP 3 654 439 A1.

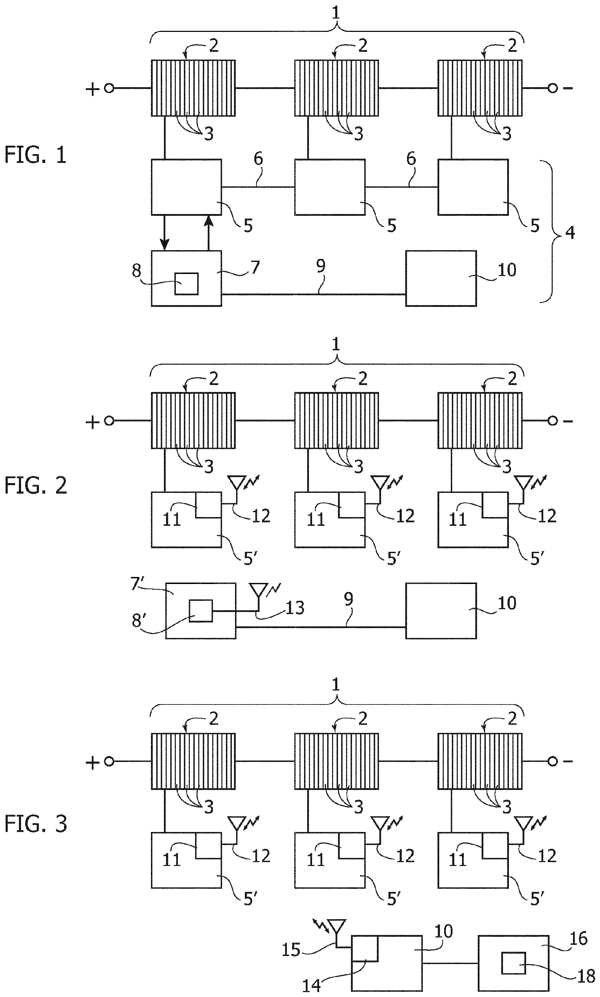

Figure 1 of the appended drawings shows the conventional configuration of a battery pack and of a Battery Management System, or "BMS", associated therewith. In this figure, reference numeral 1 generally designates a battery pack, in particular a battery pack for powering electric traction motors for electric motor-vehicles or hybrid motor-vehicles. However, it is to be understood that this application is only an example, and that the present invention is of general use.

With reference to Figure 1, the battery pack 1 comprises a plurality of battery modules 2 (purely by way of example, this figure shows the case of a battery pack consisting of three modules 2). According to a per se known technique, each battery module 2 is constituted by a plurality of battery cells 3, for example, battery cells of the lithium ion type.

Both in Figure 1 and in the following figures relating to embodiments of the present invention, the construction details of the battery modules are not illustrated, since they can be made in any known way and also because, taken alone, they do not fall within the scope of the present invention. The elimination of these details also renders the drawings simpler and easier to understand.

In the illustrated example, the battery modules 2 are connected in series with each other. On their turn, the cells 3 of each battery module 2 may be connected in series, either individually or in groups, with the cells of each group connected in parallel with each other, according to any known technique.

Again, with reference to Figure 1, which relates to the conventional solution, a BMS, generally designated by reference 4, is associated with the battery pack 1. The BMS 4 comprises a plurality of slave controllers 5 associated, respectively, with the modules 2 and connected to each other by wire connections 6. The number of slave units 5 corresponds to the number of battery modules 2. The BMS 4 comprises a main controller 7, equipped with a microprocessor 8, which is connected by wire connections with at least one of the slave units 5.

In this conventional solution, only the main controller 7 is equipped with a microprocessor, while the slave units 5 are not programmable with custom application software. Each of the slave units 5 is able to detect operating parameters of the cells 3 of the respective battery module 2, including voltage and temperature of the cells, and transmits the detected information to the main controller 7, which is able to process the received information to perform a variety of operations, including determining the state of charge and state of health of the battery pack and checking the balance of the battery pack. In the conventional solution, the main controller 7 is also connected by means of a wire connection 9 with a Battery Disconnecting Unit 10 or "BDU", and controls the operation of the BDU 10.

The document EP 3 654 439 A1 mentioned above illustrates a solution wherein the slave controllers and the main controller communicate with each other wirelessly.

US 2014/347014 A1 **discloses a wireless battery area network (WiBaAN) where a slave battery management unit S-BMU mounted on each battery cell is wirelessly connected to a single master battery management unit M-BMU (see paragraph [0036]). The WiBaAN consists of a single M-BMU (for a large battery pack size with less than 500 battery cells and a plurality of S-BMUs for individual battery cells. In figure 6 of this document, a number of units M-BMU are shown, which control respective "banks" of battery cells while, on their turn, the units M-BMU are controlled by a main controller T-BMU.**

US 2016/0268642 A1 **discloses a solution comprising a number of battery cell groups and a corresponding number of battery cell management devices. A higher level controller, namely an assembled battery management device is provided which acquires, from each battery cell management device, the measurement results related to the state of charge and the state of deterioration of the battery cell group corresponding to the battery cell management device. Then, the assembled battery management device estimates the state of charge or the state of deterioration of the battery cell group based on the obtained measurement results, and transmits the estimated results to a host controller.**

US 2021/098833 A1 **discloses a number of separate batteries, such as batteries provided at various locations in a house, having respective controllers, one of which, at its turn, dictates commands to the other battery systems, for example, whether or not to disconnect from a grid.**

### Object of the invention

The object of the present invention is to provide a new configuration for a BMS, which improves the battery pack both from the point of view of efficiency and from the point of view of operational safety.

### Summary of the invention:

In order to achieve the aforesaid object, the invention relates to a battery management system according to claim 1 and a battery management method according to claim 2.

Thanks to the aforesaid characteristics, the invention opens up new scenarios for designing a battery pack, making it possible to compose the battery pack with modules that have different health states and possibly also different cell chemistries, allowing maintenance of the battery pack, which also includes only the replacement of a single defective module. At the end of the life of a vehicle, or at the end of the life of the battery pack, even a single battery module can still be used, for example, in stationary machines and systems.

**Further preferred features are indicated in the dependent** claims.

### Detailed description of preferred embodiments

Further characteristics and advantages of the invention will become apparent from the description that follows with reference to the attached drawings, provided by way of non-limiting example, wherein:
- Figure 1 is a diagram of a battery pack and the BMS associated therewith, according to a conventional technique,
- Figure 2 is a diagram of a battery pack and a BMS according to a first embodiment, **which does not form part** of the invention, and
- Figure 3 is a diagram of a battery pack and a BMS according to an embodiment of the invention.

Figure 1 illustrates the conventional solution that has been described above.

In Figures 2 and 3, the parts corresponding to those of Figure 1 are indicated by the same reference numbers.

With reference to Figures 2, 3, a main characteristic of the present invention consists in that the battery modules 2 are associated with module controllers 5' which each comprise a microprocessor 11, so that each module controller 5' is able to perform a series of operations including determining, at each module controller 5', a state of charge of the respective battery module 2 and a state of health of the respective battery module 2, and checking a balance between the battery cells 3 of the respective battery module 2. Therefore, in the case of the invention, the information relating, for example, to the temperature and voltage of the battery cells 3 forming each battery module 2 are directly processed within the respective module controller 5'.

The embodiment illustrated in Figure 2 **(which is not part of the invention)** does comprise a main controller 7' including a microprocessor 8'.

A wireless communication unit 12 is associated with each microprocessor 11 of each module controller 5'. In the case of the embodiment of Figure 2, a wireless communication unit 13 is also associated with the microprocessor of the main controller 7'. Therefore, the module controllers 5' (and the main controller 7', in the case of the example of Figure 2) communicate with each other wirelessly.

As indicated, in each module controller 5', the microprocessor 11 is able to process the data relating to the operating parameters of the battery cells 3 of the respective battery module 2, in particular voltage and temperature, to determine the state of health and the state of charge of the respective battery module. Therefore, unlike the conventional solution, in the case of the solution of Figure 2, the aforesaid operations are no longer performed by the main controller. The main controller performs only some operations, in particular receiving information on the different battery modules from the module controllers 5' and determining a state of charge and a state of health of the entire battery pack, and checking the balance between the different battery modules.

In the case of the solution of Figure 2, moreover, similarly to the conventional solution of Figure 1, the main controller 7' is connected to the BDU 10 (which typically includes contactors with remote control, suitable for high voltages) and controls its operation.

In the case of the embodiment **according to the invention, shown in** Figure 3, the main controller is, instead, totally eliminated. In this case, each module controller 5' communicates, through its wireless communication unit 12, with the wireless communication units 12 of all the other module controllers 5', according to a mesh configuration instead of a star configuration). The microprocessors 11 of the module controllers 5' are programmed so that a single controller module 5' at a time performs, in turn, the function of a main controller, i.e. performs a series of operations including the determination of the state of health and of the state of charge of the entire battery pack and the balance between the different battery modules. The module controller 5' that each time performs the function of main controller also communicates with the BDU 10 to control its operation. To this end, in the case of the embodiment of Figure 3, the BDU 10 is provided with its own microprocessor 14 with an associated wireless communication unit 15.

In the case of the embodiment of Figure 3, the microprocessors 11 of the module controllers 5' also perform control functions for the system safety. Further management operations may also be delegated to a microprocessor 18 of an additional control unit 16 belonging to the vehicle on which the battery pack is mounted. In this case, the BDU 10 is also wired with this control unit 16 of the vehicle to also allow control of the operation of the BDU 10 by the unit 16.

Both in the case of the embodiment of Figure 2 and in the case of the embodiment of Figure 3, in order to calculate the state of charge of each battery module 2, the respective microprocessor 11 must also receive information on a measurement of current. For this purpose, in the case of both embodiments, the measurement of current may be detected by one or more module controllers 5', which - for this purpose - must have a connection channel to the respective battery module 2, for the measurement of current. In the case of the embodiment of Figure 3, the information on the measurement of current may also arrive from the BDU 10 which, being equipped with a controlling microprocessor 14, may receive the information on the measurement of current from a sensor, and communicate the value via wireless connection to all the module controllers 5'.

Naturally, without prejudice to the principle of the invention, the details of construction and the embodiments may vary widely with respect to those described and illustrated purely by way of example, without departing from the scope of the present invention.

## Claims

1. A battery management system for a battery pack (1) comprising a plurality of battery modules (2), each battery module including a plurality of battery cells (3),
said battery management system comprising:
- a plurality of module controllers (5'), associated, respectively, with said battery modules (2), each module controller (5') being configured to receive information on voltage and temperature of the battery cells (3) forming the respective battery module (2), and
- wherein each module controller (5') is provided with a wireless communication unit (12),
- wherein each of said module controllers (5') is configured and programmed to process information on voltage and temperature of the battery cells (3) of the respective battery module (2), so as to perform a series of operations including determining, in said module controller (5'), a state of charge of the respective battery module (2) and a state of health of the respective battery module (2), and checking a balance between the battery cells of the respective battery module,
- wherein each module controller (5') is also configured and programmed to transmit the state of charge and the state of health of the respective battery module (2), determined thereby, through the respective wireless communication unit (12), to at least one further wireless communication unit (12, 13),
said battery management system being **characterized in that**:
- the battery management system does not include any main controller, and
- said module controllers (5') are each configured to communicate, through the respective wireless communication unit (12), with the wireless communication unit (12) of all the other module controllers (5'),
- said module controllers also being configured and programmed so that only one of said module controllers (5') at a time performs, in turn, the function of a main controller performing a series of operations, including determining a state of charge and a state of health of the entire battery pack (1), and checking the balance between the battery modules (2),
- said module controllers (5') are further configured and programmed in such a way that the module controller (5') that each time performs the function of a main controller communicates via the respective wireless communication unit (12) with a wireless communication unit (15) associated with a controller (14) of a battery disconnecting unit (10), to control the operation of said battery disconnecting unit (10),
- in order to calculate the state of charge of each battery module (2), a respective microprocessor (11) is configured to receive information on a measurement of current, and that said controller (14) of the battery disconnecting unit (10) is configured to receive information on the measurement of current from a sensor and to communicate this information via wireless connection to all the module controllers (5').

2. A battery management method for managing a battery pack (1) comprising a plurality of battery modules (2), each battery module including a plurality of battery cells (3),
said battery management method comprising:
providing a plurality of module controllers (5') respectively associated with said battery modules (2), and receiving information at each module controller (5') on voltage and temperature of the battery cells (3) forming the respective battery module (2),
providing each module controller (5') with a wireless communication unit (12),
processing, at each module controller (5'), the information on voltage and temperature of the battery cells (3) of the respective battery module (2), and performing a series of operations, including determining, at said module controller (5'), a state of charge of the respective battery module (2) and a state of health of the respective battery module (2), and checking a balance between the battery cells (3) of the respective battery module (2), and
transmitting, at each module controller (5'), the state of charge and the state of health of the respective battery module (2), determined thereby, through the respective wireless communication unit (12), to at least one further wireless communication unit (12, 13),
said method being **characterized in that**:
- no main controller for controlling said plurality of module controllers (5') is provided,
- each module controller (5'), through the respective wireless communication unit (12), communicates with the wireless communication units (12) of all the other module controllers (5'), in such a way that only one of said module controllers (5') at a time performs, in turn, the function of a main controller, to perform a series of operations, including determining a state of charge and a state of health of the entire battery pack (1) and checking a balance between the battery modules (2),
- the module controller (5') which each time performs the function of a main controller communicates via the respective wireless communication unit (12) with a wireless communication unit (15) associated with a controller (14) of a battery disconnecting unit (10) for controlling the operation of said battery disconnecting unit,
- in order to calculate the state of charge of each battery module (2), a respective microprocessor (11) receives information on a measurement of current, from said controller (14) of the battery disconnecting unit (10), which in turn receives information on the measurement of current from a sensor and communicates this information via wireless connection to all the module controllers (5').

## Patentansprüche

1. Batteriemanagementsystem für ein Batteriepack (1), das eine Vielzahl von Batteriemodulen (2) umfasst, wobei jedes Batteriemodul eine Vielzahl von Batteriezellen (3) umfasst,
wobei das Batteriemanagementsystem umfasst:
- eine Vielzahl von Modulsteuerungen (5'), die jeweils den Batteriemodulen (2) zugeordnet sind, wobei jede Modulsteuerung (5') dazu eingerichtet ist, Informationen über Spannung und Temperatur der Batteriezellen (3) zu empfangen, die das jeweilige Batteriemodul (2) bilden, und
- wobei jede Modulsteuerung (5') mit einer Drahtloskommunikationseinheit (12) versehen ist,
- wobei jede der Modulsteuerungen (5') dazu eingerichtet und programmiert ist, Informationen über Spannung und Temperatur der Batteriezellen (3) des jeweiligen Batteriemoduls (2) zu verarbeiten, um eine Reihe von Tätigkeiten auszuführen, die das Bestimmen in der Modulsteuerung (5') eines Ladezustands des jeweiligen Batteriemoduls (2) und eines Gesundheitszustands des jeweiligen Batteriemoduls (2) sowie das Prüfen eines Gleichgewichts zwischen den Batteriezellen des jeweiligen Batteriemoduls umfassen,
- wobei jede Modulsteuerung (5') außerdem dazu eingerichtet und programmiert ist, den Ladezustand und den Gesundheitszustand des jeweiligen Batteriemoduls (2), die dadurch bestimmt wurden, vermittels der jeweiligen Drahtloskommunikationseinheit (12) an mindestens eine weitere Drahtloskommunikationseinheit (12, 13) zu übermitteln,
wobei das Batteriemanagementsystem **dadurch gekennzeichnet ist, dass**:
- das Batteriemanagementsystem keine Hauptsteuerung umfasst, und
- die Modulsteuerungen (5') jeweils dazu eingerichtet sind, vermittels der jeweiligen Drahtloskommunikationseinheit (12) mit der Drahtloskommunikationseinheit (12) aller anderen Modulsteuerungen (5') zu kommunizieren,
- die Modulsteuerungen außerdem derart eingerichtet und programmiert sind, dass immer nur eine der Modulsteuerungen (5') ihrerseits die Funktion einer Hauptsteuerung ausübt, die eine Reihe von Tätigkeiten ausführt, die das Bestimmen eines Ladezustands und eines Gesundheitszustands des gesamten Batteriepacks (1) und das Prüfen des Gleichgewichts zwischen den Batteriemodulen (2) umfassen,
- die Modulsteuerungen (5') ferner derart eingerichtet und programmiert sind, dass die Modulsteuerung (5'), die jeweils die Funktion einer Hauptsteuerung ausübt, über die jeweilige Drahtloskommunikationseinheit (12) mit einer Drahtloskommunikationseinheit (15) kommuniziert, die einer Steuerung (14) einer Batterietrenneinheit (10) zugeordnet ist, um den Betrieb der Batterietrenneinheit (10) zu steuern,
- ein entsprechender Mikroprozessor (11) zum Berechnen des Ladezustands von jedem Batteriemodul (2) dazu eingerichtet ist, Informationen über eine Strommessung zu empfangen, und die Steuerung (14) der Batterietrenneinheit (10) dazu eingerichtet ist, Informationen über die Strommessung von einem Sensor zu empfangen und diese Informationen über eine Drahtlosverbindung an alle Modulsteuerungen (5') zu übermitteln.

2. Batteriemanagementverfahren für das Management eines Batteriepacks (1), das eine Vielzahl von Batteriemodulen (2) umfasst, wobei jedes Batteriemodul eine Vielzahl von Batteriezellen (3) umfasst,
wobei das Batteriemanagementverfahren umfasst:
Bereitstellen einer Vielzahl von Modulsteuerungen (5'), die jeweils den Batteriemodulen (2) zugeordnet sind, und Empfangen bei jeder Modulsteuerung (5') von Informationen über Spannung und Temperatur der Batteriezellen (3), die das jeweilige Batteriemodul (2) bilden,
Ausstatten jeder Modulsteuerung (5') mit einer Drahtloskommunikationseinheit (12),
Verarbeiten bei jeder Modulsteuerung (5') der Informationen über Spannung und Temperatur der Batteriezellen (3) des jeweiligen Batteriemoduls (2) und Ausführen einer Reihe von Tätigkeiten, die das Bestimmen bei der Modulsteuerung (5') eines Ladezustands des jeweiligen Batteriemoduls (2) und eines Gesundheitszustands des jeweiligen Batteriemoduls (2) sowie das Prüfen eines Gleichgewichts zwischen den Batteriezellen (3) des jeweiligen Batteriemoduls (2) umfassen, und
Übermitteln bei jeder Modulsteuerung (5') des Ladezustands und des Gesundheitszustands des jeweiligen Batteriemoduls (2), die dadurch bestimmt wurden, vermittels der jeweiligen Drahtloskommunikationseinheit (12) an mindestens eine weitere Drahtloskommunikationseinheit (12, 13),
wobei das Verfahren **dadurch gekennzeichnet ist, dass**:
- keine Hauptsteuerung zum Steuern der Vielzahl von Modulsteuerungen (5') vorgesehen ist,
- jede Modulsteuerung (5') vermittels der jeweiligen Drahtloskommunikationseinheit (12) derart mit den Drahtloskommunikationseinheiten (12) aller anderen Modulsteuerungen (5') kommuniziert, dass immer nur eine der Modulsteuerungen (5') ihrerseits die Funktion einer Hauptsteuerung ausübt, um eine Reihe von Tätigkeiten auszuführen, die das Bestimmen eines Ladezustands und eines Gesundheitszustands des gesamten Batteriepacks (1) und das Prüfen eines Gleichgewichts zwischen den Batteriemodulen (2) umfassen,
- die Modulsteuerung (5'), die jeweils die Funktion einer Hauptsteuerung ausübt, über die jeweilige Drahtloskommunikationseinheit (12) mit einer Drahtloskommunikationseinheit (15) kommuniziert, die einer Steuerung (14) einer Batterietrenneinheit (10) zugeordnet ist, um den Betrieb der Batterietrenneinheit zu steuern,
- ein entsprechender Mikroprozessor (11) zum Berechnen des Ladezustands von jedem Batteriemodul (2) Informationen über eine Strommessung von der Steuerung (14) der Batterietrenneinheit (10) empfängt, die ihrerseits Informationen über die Strommessung von einem Sensor empfängt und diese Informationen über eine Drahtlosverbindung an alle Modulsteuerungen (5') übermittelt.

## Revendications

1. Système de gestion de batterie pour un bloc-batterie (1) comprenant une pluralité de modules de batterie (2), chaque module de batterie comprenant une pluralité d'éléments de batterie (3),
ledit système de gestion de batterie comprenant :
- une pluralité de dispositifs de commande de module (5'), associés respectivement auxdits modules de batterie (2), chaque dispositif de commande de module (5') étant configuré pour recevoir des informations sur la tension et la température des éléments de batterie (3) formant le module de batterie respectif (2), et
- dans lequel chaque dispositif de commande de module (5') est muni d'une unité de communication sans fil (12),
- dans lequel chacun desdits dispositifs de commande de module (5') est configuré et programmé pour traiter les informations sur la tension et la température des éléments de batterie (3) du module de batterie respectif (2), afin de réaliser une série d'opérations comprenant la détermination, dans ledit dispositif de commande de module (5'), d'un état de charge du module de batterie respectif (2) et d'un état de santé du module de batterie respectif (2), et la vérification de l'équilibre entre les éléments de batterie du module de batterie respectif,
- dans lequel chaque dispositif de commande de module (5') est également configuré et programmé pour transmettre l'état de charge et l'état de santé du module de batterie respectif (2), déterminés ainsi, à travers l'unité de communication sans fil respective (12), à au moins une unité de communication sans fil supplémentaire (12, 13),
ledit système de gestion de batterie étant **caractérisé en ce que** :
- le système de gestion de batterie ne comprend pas de dispositif de commande principal, et
- lesdits dispositifs de commande de module (5') sont chacun configurés pour communiquer, à travers l'unité de communication sans fil respective (12), avec l'unité de communication sans fil (12) de tous les autres dispositifs de commande de module (5'),
- lesdits dispositifs de commande de module étant également configurés et programmés de sorte qu'un seul desdits dispositifs de commande de module (5') à la fois réalise à son tour la fonction d'un dispositif de commande principal réalisant une série d'opérations, comprenant la détermination d'un état de charge et d'un état de santé de l'ensemble du bloc-batterie (1), et la vérification de l'équilibre entre les modules de batterie (2),
- lesdits dispositifs de commande de module (5') sont en outre configurés et programmés de sorte que le dispositif de commande de module (5') qui réalise à chaque fois la fonction d'un dispositif de commande principal, communique via l'unité de communication sans fil respective (12) avec une unité de communication sans fil (15) associée à un dispositif de commande (14) d'une unité de déconnexion de batterie (10), pour commander le fonctionnement de ladite unité de déconnexion de batterie (10),
- afin de calculer l'état de charge de chaque module de batterie (2), un microprocesseur respectif (11) est configuré pour recevoir des informations sur une mesure de courant, et ledit dispositif de commande (14) de l'unité de déconnexion de batterie (10) est configuré pour recevoir des informations sur la mesure de courant d'un capteur et pour communiquer ces informations via une connexion sans fil à tous les dispositifs de commande de module (5').

2. Procédé de gestion de batterie pour la gestion d'un bloc-batterie (1) comprenant une pluralité de modules de batterie (2), chaque module de batterie comprenant une pluralité d'éléments de batterie (3),
ledit procédé de gestion de batterie comprenant :
la fourniture d'une pluralité de dispositifs de commande de module (5') associés respectivement auxdits modules de batterie (2), et la réception d'informations, au niveau de chaque dispositif de commande de module (5'), sur la tension et la température des éléments de batterie (3) formant le module de batterie respectif (2),
la fourniture à chaque dispositif de commande de module (5') d'une unité de communication sans fil (12),
le traitement, au niveau de chaque dispositif de commande de module (5'), des informations sur la tension et la température des éléments de batterie (3) du module de batterie respectif (2), et la réalisation d'une série d'opérations, comprenant la détermination, au niveau dudit dispositif de commande de module (5'), d'un état de charge du module de batterie respectif (2) et d'un état de santé du module de batterie respectif (2), et la vérification de l'équilibre entre les éléments de batterie (3) du module de batterie respectif (2), et
la transmission, au niveau de chaque dispositif de commande de module (5'), de l'état de charge et de l'état de santé du module de batterie respectif (2), déterminés ainsi, à travers l'unité de communication sans fil respective (12), à au moins une unité de communication sans fil supplémentaire (12, 13),
ledit procédé étant **caractérisé en ce que** :
- aucun dispositif de commande principal pour la commande de ladite pluralité de dispositifs de commande de module (5') n'est fourni,
- chaque dispositif de commande de module (5'), à travers l'unité de communication sans fil respective (12), communique avec les unités de communication sans fil (12) de tous les autres dispositifs de commande de module (5'), de sorte qu'un seul desdits dispositifs de commande de module (5') à la fois réalise à son tour la fonction d'un dispositif de commande principal pour réaliser une série d'opérations, comprenant la détermination d'un état de charge et d'un état de santé de l'ensemble du bloc-batterie (1) et la vérification de l'équilibre entre les modules de batterie (2),
- le dispositif de commande de module (5') qui réalise à chaque fois la fonction d'un dispositif de commande principal, communique via l'unité de communication sans fil respective (12) avec une unité de communication sans fil (15) associée à un dispositif de commande (14) d'une unité de déconnexion de batterie (10) pour commander le fonctionnement de ladite unité de déconnexion de batterie,
- afin de calculer l'état de charge de chaque module de batterie (2), un microprocesseur respectif (11) reçoit des informations sur une mesure de courant, dudit dispositif de commande (14) de l'unité de déconnexion de batterie (10), qui reçoit, à son tour, des informations sur la mesure de courant d'un capteur et communique ces informations via une connexion sans fil à tous les dispositifs de commande de module (5').
